# EUROPEAN PATENT APPLICATION

(11) **EP 2 424 032 A1**
(43) Date of publication of application: **29.02.2012**
(21) Application number: 10767054.9
(22) Date of filing: 20.04.2010
(51) Int. Cl.: H01M 14/00, H01L 31/04, H01M 8/06

(54) **PHOTOVOLTAIC CELL**

(30) Priority: 20.04.2009 JP 2009119239
(71) Applicant: Fukutome, Hirofumi, Fukuoka 815-0083 (JP)
(72) Inventor: ISHIBASHI Toru, Nagasaki-shi Nagasaki 852-8155 (JP)
(74) Representative: AMMANN PATENTANWÄLTE AG BERN
(86) International application number: PCT/JP2010/056994
(87) International publication number: WO 2010/122997

(57) **Abstract**

A photovoltaic cell using lignin and porphyrin as materials is prepared. In the photovoltaic cell, hydrogen ions are liberated using lignin as the material, an alkaline solution, a pyrrole compound such as porphyrin, and optical energy such as ultraviolet rays or sunlight.

## Description

### [Technical Field]

This invention relates to a photovoltaic cell, which is useful when applied in obtaining electric power by irradiating an alkaline solution of lignin and porphyrin with light, particularly, sunlight.

### [Prior Art]

Global warming has accelerated since the beginning of the 21st century, and the reduction of emitted carbon dioxide becomes a key to controlling the industrial world and, in turn, the economy of the world. Insofar as fossil fuels enclosed in the underground and/or the sea floor or bed are used as an energy source, it would be difficult to decrease the amount of carbon dioxide in the atmosphere, and even to curtail its increase. Under these circumstances, attention is focused on fuel cells in which an electromotive force is generated by the migration of hydrogen ions. When a hydrogen gas is to be used as a source of hydrogen ions, however, most of the hydrogen gas is currently produced from the fossil fuel. A hydrogen gas can also be obtained by the electrolysis of water, but even in this case, electric power needs to be supplied.

In the case of a solar cell in which electric power is obtained from sunlight, the production of a semiconductor is necessary. Enormous amounts of resources and a huge cost are required for this purpose, if the current demands for energy are to be satisfied by the solar cell. For dye-sensitized solar cells, nano-size titanium oxide is needed, and a synthetic dyestuff which provides a certain degree of electromotive force is expensive.

Alcohols such as bioethanol prepared from plants are also promising as an energy source. However, most of conventional technologies for preparing such bioethanol have used sugars as starting materials, thus posing the problem that a resource conflict occurs between a food source for mankind and the energy source. Recently, there have been developed, at long last, advanced technologies for preparing alcohols which use cellulose, etc. as a carbon source while avoiding conflict with the food source. Woods and grass or weeds, which are not edible, consist mainly of cellulose and lignin. Scrap wood and chip-like wood are generally waste materials and unsuitable as construction materials. By using such woody materials or cellulose materials from grass or weeds as carbon sources, emissions of carbon dioxide can be suppressed, contributing to the industrial world and the economic world.

Contrary to the above progress in the utilization of cellulose, the effective use of lignin, which is an abundant carbon source like the cellulose, is still extremely limited. Examples of practical use of lignin include its simple combustion as a heat source, its use as an antiseptic, and its use as a structure-reinforcing material incorporated into concrete.

### [Summary of the Invention]

### [Problems to be solved by the invention]

The present invention has been accomplished in light of the above-described conventional technologies. It is an object of the present invention to provide a novel photovoltaic cell which can obtain electric power by irradiation with light, such as sunlight, without using a semiconductor as a raw material.

### [Means for solving the problems]

A first aspect of the present invention for attaining the above object is a photovoltaic cell comprising: a cell formed by charging an alkaline solution, which contains lignin and porphyrin as solutes, into a space at least partly formed by a transparent member pervious to light; and a pair of electrodes provided to oppose the alkaline solution of the cell while making contact with the alkaline solution.

A second aspect of the present invention is a photovoltaic cell comprising: one cell formed by charging an alkaline solution, which contains lignin and porphyrin as solutes, into one of at least two spaces separated from each other by a membrane, the one cell being at least partly formed by a transparent member pervious to light; the other cell formed by charging the alkaline solution into the other of the spaces; one electrode in contact with the alkaline solution of the one of the cells; and the other electrode in contact with the alkaline solution of the other of the cells.

A third aspect of the present invention is a photovoltaic cell comprising: one cell formed by charging an alkaline solution, which contains lignin as a solute, into one of at least two spaces separated from each other by a membrane, the one cell being at least partly formed by a transparent member pervious to light; the other cell formed by charging the alkaline solution into the other of the spaces; one electrode in contact with the alkaline solution of the one of the cells; and the other electrode in contact with the alkaline solution of the other of the cells.

A fourth aspect of the present invention is a photovoltaic cell comprising: one cell formed by charging an alkaline solution, which contains porphyrin as a solute, into one of at least two spaces separated from each other by a membrane, the one cell being at least partly formed by a transparent member pervious to light; the other cell formed by charging the alkaline solution into the other of the spaces; one electrode in contact with the alkaline solution of the one of the cells; and the other electrode in contact with the alkaline solution of the other of the cells.

A fifth aspect of the present invention is the photovoltaic cell according to any one of the first to fourth aspects, wherein the alkaline solution is a solution of potassium hydroxide.

A sixth aspect of the present invention is the photovoltaic cell according to any one of the second to fifth aspects, wherein the membrane is formed of an ion exchange membrane.

A seventh aspect of the present invention is the photovoltaic cell according to any one of the second to fifth aspects, wherein the membrane is formed of a water repellent carbon membrane.

An eighth aspect of the present invention is the photovoltaic cell according to the first, second or fourth aspect, wherein the porphyrin is coproporphyrin.

### [Effects of the invention]

According to the present invention, a photovoltaic cell can be produced, and hydrogen ions imparting an electromotive force to a fuel cell can be liberated from lignin, by using sunlight and a pyrrole compound produced biologically, without requiring a special production apparatus or production method such as a system of chemical synthesis of an organic compound. Moreover, the raw material is lignin which is inexpensive and obtained in large quantity and whose effective use is considered so difficult that it is handled almost as if to be a waste. Hence, the present invention plays an extremely important role in human society where it is an urgent necessity to solve the problem of carbon dioxide.

That is, according to the present invention, a photovoltaic cell can be prepared using lignin and a pyrrole compound, such as porphyrin, as materials, and a potential difference can be generated simply by irradiating a mixture of lignin and porphyrin with light such as sunlight or ultraviolet rays.

The material used in the present invention is lignin which is a non-fossil fuel and a carbon resource present in abundance, although its effective use has not been made. Electric power can be obtained from this lignin with the use of natural energy such as solar energy.

### [Brief Description of the Drawings]

### [Figure 1]

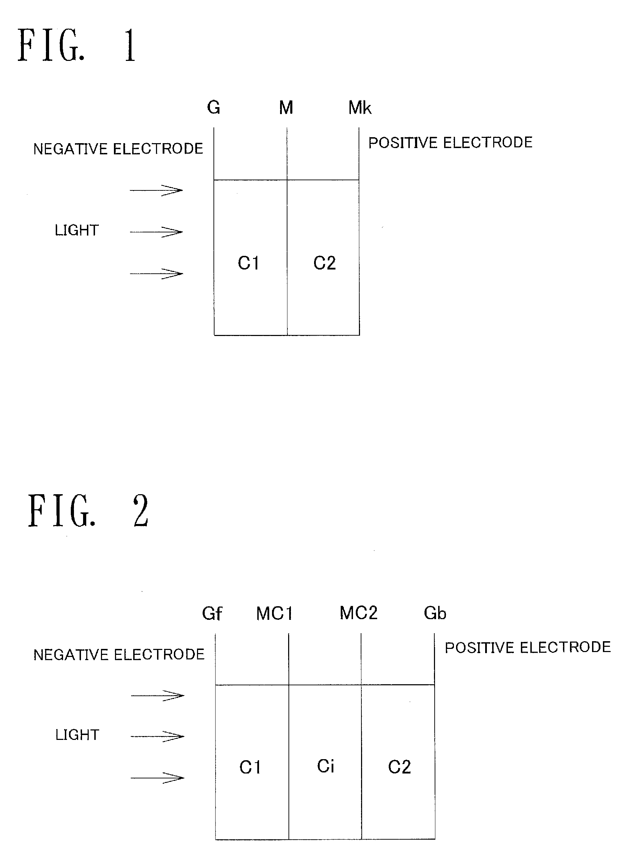

Fig. 1 is an explanation drawing conceptually showing a photovoltaic cell according to a first embodiment of the present invention.

### [Figure 2]

Fig. 2 is an explanation drawing conceptually showing a photovoltaic cell according to a second embodiment of the present invention.

### [Figure 3]

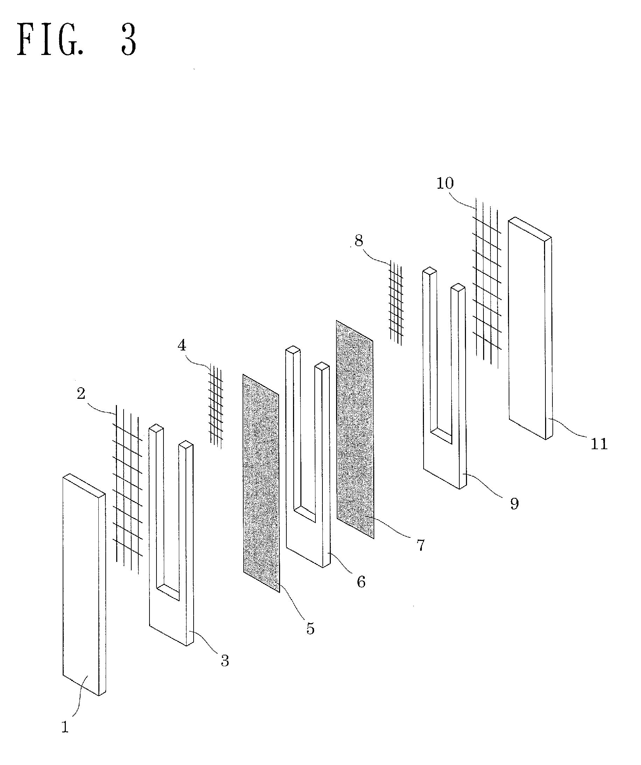

Fig. 3 is an exploded perspective view showing, in an exploded configuration, a photovoltaic cell according to a third embodiment of the present invention.

### [Figure 4]

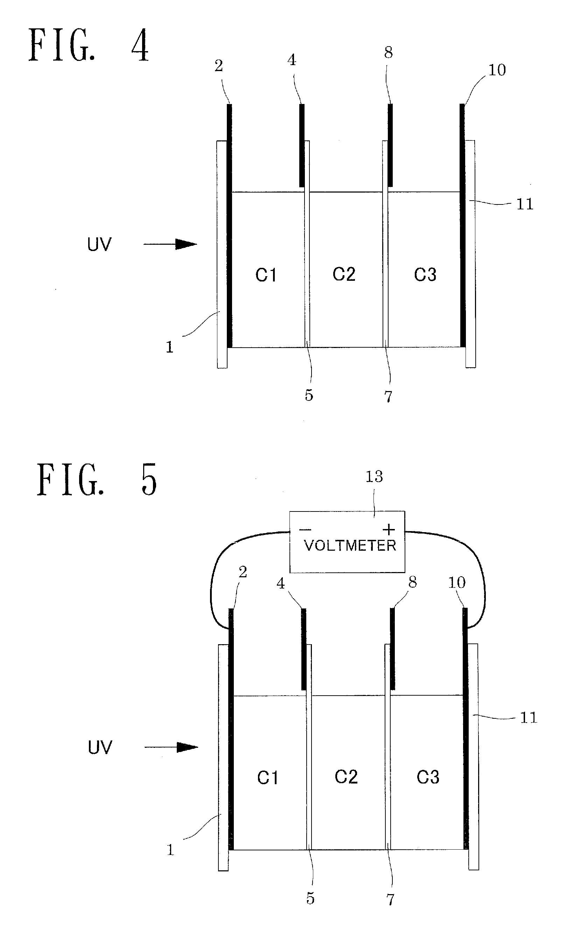

Fig. 4 is an explanation drawing conceptually showing the photovoltaic cell illustrated in Fig. 3.

### [Figure 5]

Fig. 5 is an explanation drawing showing a mode during the measurement of a voltage obtained by the photovoltaic cell illustrated in Fig. 3.

### [Figure 6]

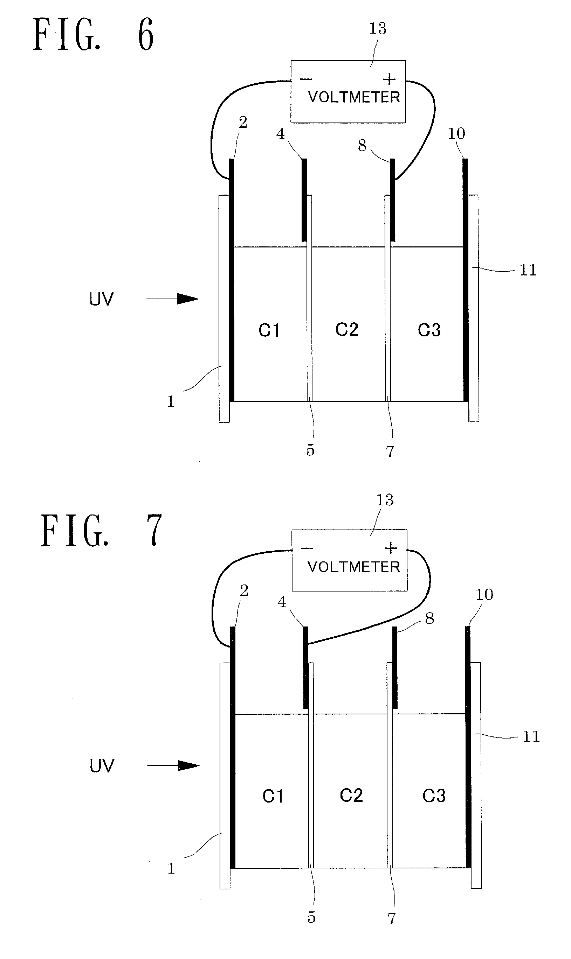

Fig. 6 is an explanation drawing showing a mode during the measurement of a voltage obtained by the photovoltaic cell illustrated in Fig. 3.

### [Figure 7]

Fig. 7 is an explanation drawing showing a mode during the measurement of a voltage obtained by the photovoltaic cell illustrated in Fig. 3.

### [Figure 8]

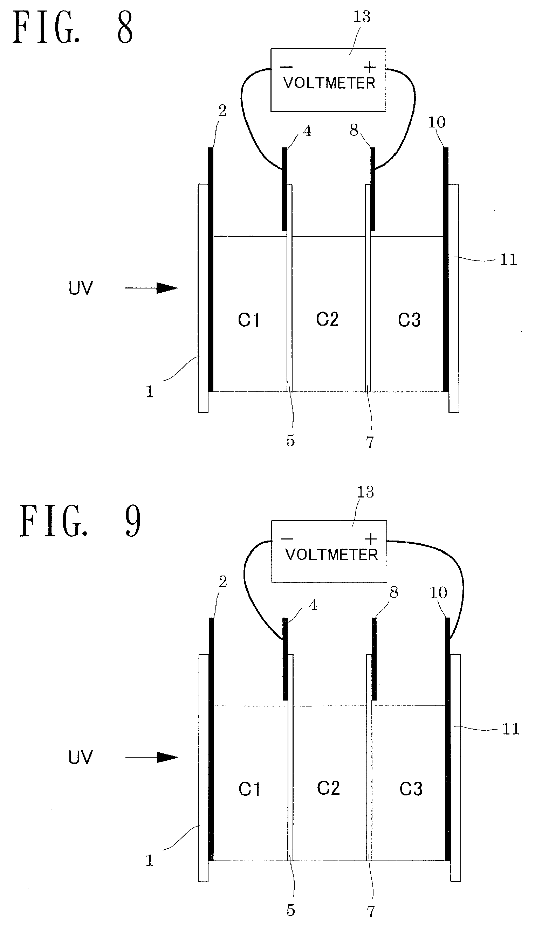

Fig. 8 is an explanation drawing showing a mode during the measurement of a voltage obtained by the photovoltaic cell illustrated in Fig. 3.

### [Figure 9]

Fig. 9 is an explanation drawing showing a mode during the measurement of a voltage obtained by the photovoltaic cell illustrated in Fig. 3.

### [Figure 10]

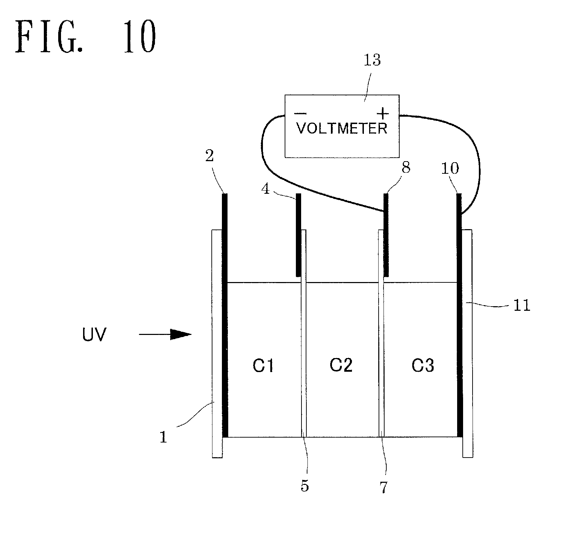

Fig. 10 is an explanation drawing showing a mode during the measurement of a voltage obtained by the photovoltaic cell illustrated in Fig. 3.

### [Mode for Carrying Out the Invention]

The embodiments of the present invention will now be described in detail below.

For the alkaline solution used in the present invention, KOH or NaOH in an amount of the order of 0.005M to 0.05M, for example, is preferred. As the lignin, a product having high purity and free of impurities such as a reducing sugar and cellulose (a product available from SIGMA Company under the Catalogue No. 471003 and having a molecular weight of 60,000) is preferred. As the porphyrin, coproporphyrin produced biologically using *Escherichia coli* (PCT/JP2008/071828), for example, can be used as a catalyst. As synthetic porphyrin, there can be used, for example, Protoporphyrin IX (ALDRICH Company) carrying two carboxyl groups in the molecule; Coproporphyrin I (ALDRICH Company) carrying 4 carboxyl groups in the molecule; and Uroporphyrin I (SIGMA Company) carrying 8 carboxyl groups in the molecule. None of these porphyrins have a metal atom coordinated at the center of the porphyrin ring.

Fig. 1 is an explanation drawing conceptually showing a photovoltaic cell according to a first embodiment of the present invention. As shown in this drawing, a negative electrode and a positive electrode are installed in cells, i.e., C1 and C2, which are separated from each other by an ion exchange membrane M, such as cellophane, in the photovoltaic cell according to the present embodiment. A glass electrode G is used as a conductor of the negative electrode, while a platinum catalyst-equipped carbon electrode MK (Pt 2.0 mg/cm² TGP-H-060: Chemix Co., Ltd.) is used as a conductor of the positive electrode. The C1 is charged with 50 mM KOH, 50 µ/ml coproporphyrin (produced using E. coli as described in PCT/JP2008/071828), and 2.5 mg/ml of a lignin solution, whereas the C2 is charged with 50 mM KOH. The glass electrode G on the negative electrode side was irradiated with UV light (ultraviolet light; the same applies hereinafter) at 365 nm. During irradiation, a voltage increase of 31.2 mV and a current of 0.2 µA were measured. When the light irradiation was discontinued, this potential difference and the current promptly disappeared. Practically the same electric power can be obtained with the use of the above-mentioned Coproporphyrin I (ALDRICH Company) as the coproporphyrin.

Fig. 2 is an explanation drawing conceptually showing a photovoltaic cell according to a second embodiment of the present invention. In the photovoltaic cell according to the present embodiment, a negative electrode and a positive electrode are installed in the cells C1 and C2, which are separated from each other by two layers of water repellent carbon, i.e., MC1 and MC2, and an intermediate cell Ci interposed between these two layers, as shown in the drawing. A glass electrode Gf is used as a conductor of the negative electrode, while a glass electrode Gb is used as a conductor of the positive electrode. A solution used for C1 contains 50 mM KOH, 50 µ/ml of coproporphyrin (produced using E. coli as described in PCT/JP2008/071828), and 2.5 mg/ml of a lignin solution. A solution used for Ci contains 50 mM KOH. A solution used for C2 contains 50 mM KOH and 1 mM potassium permanganate (KMnO₄). The glass electrode Gf on the negative electrode side was irradiated with UV light at 365 nm. During irradiation, a voltage increase of 32.0 mV and a current of 0.4 µA were measured. When the light irradiation was discontinued, this potential difference and the current promptly disappeared. In this system, the positive electrode of the photovoltaic cell may be installed on the MC2, rather than on the glass electrode Gb. Even in this case, upon irradiation of the glass electrode Gf on the negative electrode side with UV light at 365 nm, a voltage increase of 21.6 mV and a current of 0.2 µA were measured. This potential difference and the current promptly disappeared when the light irradiation was discontinued. Practically the same electric power can be obtained with the use of the above-mentioned Synthetic Coproporphyrin I (ALDRICH Company) as the coproporphyrin.

Fig. 3 is an exploded perspective view showing, in an exploded configuration, a photovoltaic cell according to a third embodiment of the present invention. Fig. 4 is an explanation drawing conceptually showing the photovoltaic cell illustrated in Fig. 3. As shown in both drawings, the photovoltaic cell is constructed by integrally combining a front member 1, an electrode 2, a spacer 3, an electrode 4, a membrane 5, a spacer 6, a membrane 7, an electrode 8, a spacer 9, an electrode 10, and a back member 11 in this order. This photovoltaic cell has three cells, i.e., a cell C1 defined between the front member 1 and the membrane 5 by the spacer 3, a cell C2 defined between the membrane 5 and the membrane 7 by the spacer 3, and a cell C3 defined between the membrane 7 and the back member 11 by the spacer 9. The material for the front member 1, in the present embodiment, is preferably glass which is a transparent member pervious to light, but need not be limited as long as it is a member pervious to light. The electrode 2 is secured to the front member 1 and, likewise, the electrode 4 is secured to the membrane 5, the electrode 8 is secured to the membrane 7, and the electrode 10 is secured to the back member 11. The spacers 3, 6 and 9, in the present embodiment, are each formed, for example, by cutting a 1.5 mm thick polyvinyl chloride sheet into a U-shaped form. The membranes 5 and 7 can each be preferably formed from cellophane, a carbon membrane, a water repellent carbon membrane, a carbon membrane with a catalyst, or an ion exchange membrane. The electrodes 2, 4, 8 and 10 are each formed from a mesh sheet of stainless steel which is a conductive member. For the back member 11, its material need not be restricted, but in the case of the present Embodiment, the back member 11 is formed from glass as a material. The cell C1 which is irradiated with light is charged with an alkaline solution of lignin, together with porphyrin as a photocatalyst, for example, a solution dissolved in potassium hydroxide or sodium hydroxide. The cells C2 and C3 are charged with an alkaline solution, like the cell C1. As a result, the electrode 2 is immersed in the alkaline solution charged into the cell C1 and having lignin and porphyrin dissolved therein, while the electrode 10 is immersed in the alkaline solution charged into the cell C3 , whereby each electrode is in contact with the alkaline solution. The electrodes 4, 8 are in contact with the alkaline solution via the membranes 5, 7. In the present embodiment as well, the same lignin and porphyrin as those in the aforementioned embodiments can be used.

When, in such a photovoltaic cell, light is entered into the alkaline solution of the cell C1 via the front member 1, a voltage occurs between the electrodes 2, 4, 8 and 10. That is, this configuration functions as a photovoltaic cell.

To confirm the occurrence of such a voltage, a combination of the components of the solution charged into the cell C1 was changed in the structure illustrated in Figs. 3 and 4, and a voltage occurring between the electrodes was measured. Concretely, the following four cases were provided: 1) The cell C1 was charged with a KOH solution (50 mM), while the cells C2, C3 were charged with a KOH solution. 2) The cell C1 was charged with a KOH solution (50 mM) having coproporphyrin (50 µg/ml) dissolved therein, while the cells C2, C3 were charged with a KOH solution. 3) The cell C1 was charged with a KOH solution (50 mM) having lignin (2500 µg/ml) dissolved therein, while the cells C2, C3 were charged with a KOH solution. 4) The cell C1 was charged with a KOH solution (50 mM) having coproporphyrin (50 µm/ml) and lignin (2500 µg/ml) dissolved therein, while the cells C2, C3 were charged with a KOH solution. In these four cases, a voltmeter 13 was connected to the electrodes, with the state of connection to the electrodes 2, 4, 8, 10 being changed, as shown in Figs. 5 to 10. In each of the cases, the values of voltage were measured before UV light irradiation and after UV light irradiation (after 3 minutes of irradiation) . For each case, three measurements were made before and after the irradiation, and the average change in the measured value was determined in each case.

Tables 1 to 6 show the results. The manner of connection in Fig. 5 corresponds to the results of Table 1, the manner of connection in Fig. 6 corresponds to the results of Table 2, the manner of connection in Fig. 7 corresponds to the results of Table 3, the manner of connection in Fig. 8 corresponds to the results of Table 4, the manner of connection in Fig. 9 corresponds to the results of Table 5, and the manner of connection in Fig. 10 corresponds to the results of Table 6.

**[Table 1]**

| Composition of C1, C2, C3 | | | Voltage (mV) before and after UV irradiation | |
|---|---|---|---|---|
| C1 | C2 | C3 | Before → After | Average change |
| KOH | KOH | KOH | -10.8 → 1.9 | +7.1 |
| | | | -4.9 → -0.1 | |
| | | | -5.9 → -2.2 | |
| KOH | KOH | KOH | -31.0 → 40.6 | -3.0 |
| Coproporphyrin | | | -50.8 → -52.7 | |
| | | | -55.7 → -52.3 | |
| KOH | KOH | KOH | -5.8 → -11.3 | -3.6 |
| Lignin | | | -11.3 → -14.3 | |
| | | | -12.1 → -14.5 | |
| KOH | KOH | KOH | -23.8 → 51.7 | +73.1 |
| Coproporphyrin | | | -15,6 → 60.4 | |
| Lignin | | | -16.2 → 51.7 | |

**[Table 2]**

| Composition of C1, C2, C3 | | | Voltage (mV) before and after UV irradiation | |
|---|---|---|---|---|
| C1 | C2 | C3 | Before → After | Average change |
| KOH | KOH | KOH | -81.2 → -65.8 | +10.0 |
| | | | -75.9 → -65.8 | |
| | | | -77.4 → -72.8 | |
| KOH | KOH | KOH | -32.9 → -22.0 | +6.8 |
| Coproporphyrin | | | -26.0 → -21.3 | |
| | | | -25.9 → -21.0 | |
| KOH | KOH | KOH | -88.1 → -76.4 | +5.3 |
| Lignin | | | -79.7 → -76.9 | |
| | | | -79.6 → -78.2 | |
| KOH | KOH | KOH | -48.9 → 28.0 | +73.0 |
| Coproporphyrin | | | -34.6 → 60.4 | |
| Lignin | | | -38.2 → 33.2 | |

**[Table 3]**

| Composition of C1, C2, C3 | | | Voltage (mV) before and after UV irradiation | |
|---|---|---|---|---|
| C1 | C2 | C3 | Before → After | Average change |
| KOH | KOH | KOH | -62.8 → -56.1 | +6.8 |
| | | | -66.1 → -59.5 | |
| | | | -67.3 → -60.3 | |
| KOH | KOH | KOH | -92.8 → -75.3 | +9.1 |
| Coproporphyrin | | | -82.0 → -76.8 | |
| | | | -84.2 → -79.0 | |
| KOH | KOH | KOH | -77.1 → -72.8 | +3.9 |
| Lignin | | | -76.2 → -72.6 | |
| | | | -75.8 → -72.0 | |
| | | | -87.3 → -8.5 | +65.9 |
| Coproporphyrin | | | -66.8 → -8.1 | |
| Lignin | | | -68.7 → -8.6 | |

**[Table 4]**

| Composition of C1, C2, C3 | | | Voltage (mV) before and after UV irradiation | |
|---|---|---|---|---|
| C1 | C2 | C3 | Before → After | Average change |
| KOH | KOH | KOH | 36.2 → 36.0 | -0.8 |
| | | | 37.9 → 36.8 | |
| | | | 37.9 → 36.9 | |
| KOH | KOH | KOH | 64.7 → 74.7 | +6.6 |
| Coproporphyrin | | | 83.3 → 93.0 | |
| | | | 112.9 → 112.9 | |
| KOH | KOH | KOH | 56.4 → 51.6 | -2.1 |
| Lignin | | | 64.1 → 58.4 | |
| | | | 53.0 → 62.8 | |
| KOH | KOH | KOH | 17.7 → 16.9 | -0.9 |
| Coproporphyrin | | | 18.7 → 17.6 | |
| Lignin | | | 18.1 → 17.2 | |

**[Table 5]**

| Composition of C1, C2, C3 | | | Voltage (mV) before and after UV irradiation | |
|---|---|---|---|---|
| C1 | C2 | C3 | Before → After | Average change |
| KOH | KOH | KOH | 106.7 → 96.2 | -8.9 |
| | | | 106.9 → 98.5 | |
| | | | 108.5 → 100.7 | |
| KOH | KOH | KOH | 105.7 → 95.2 | -9.7 |
| Coproporphyrin | | | 103.4 → 93.7 | |
| | | | 101.1 → 92.2 | |
| KOH | KOH | KOH | 105.3 → 95.5 | -6.8 |
| Lignin | | | 99.4 → 93.2 | |
| | | | 98.8 → 94.5 | |
| KOH | KOH | KOH | 97.5 → 87.5 | -8.6 |
| Coproporphyrin | | | 95.8 → 88.6 | |
| Lignin | | | 97.2 → 88.6 | |

**[Table 6]**

| Composition of C1, C2, C3 | | | Voltage (mV) before and after UV irradiation | |
|---|---|---|---|---|
| C1 | C2 | C3 | Before → After | Average change |
| KOH | KOH | KOH | 30.0 → 17.5 | -11.7 |
| | | | 28.6 → 16.5 | |
| | | | 27.4 → 16.9 | |
| KOH | KOH | KOH | 96.1 → 86.8 | +7.9 |
| Coproporphyrin | | | 92.4 → 84.8 | |
| | | | 91.5 → 84.6 | |
| KOH | KOH | KOH | 53.0 → 40.5 | -10.6 |
| Lignin | | | 46.6 → 36.7 | |
| | | | 44.4 → 34.9 | |
| KOH | KOH | KOH | 40.0 → 29.7 | -8.0 |
| Coproporphyrin | | | 36.2 → 29.2 | |
| Lignin | | | 35.1 → 28.6 | |

As shown in Tables 1 to 6, certain voltages were measured in the respective cases after irradiation with UV light. Thus, the structures shown in the drawings were confirmed to function as photovoltaic cells. Of them, the structures in which the cell C1 was charged with KOH having lignin and porphyrin dissolved therein and whose connections were as shown in Figs. 5 to 6 were found to be preferred.

It seems that the voltage values shown in Tables 1 to 6 occurred even before irradiation with UV light. However, this phenomenon is considered to have been observed, because the experimental environment was not completely shielded from light, and the accuracy of the voltmeter 13 was problematical. It is true, however, that the resulting voltage differed according to whether UV light was incident or not.

The results of Table 3 show that when the KOH solution using porphyrin and lignin as solutes is irradiated with light, the mere connection to the cell C1 provides a certain high voltage. If a cell is constituted by an alkaline solution containing porphyrin and lignin as solutes, one cell is enough to form a predetermined photovoltaic cell.

In short, the present invention is based on the discovery that a potential difference can be produced if lignin is irradiated with light. Thus, methods of generating voltage by light irradiation, and photovoltaic cells, which are based on this discovery, are all included in the technical idea of the present invention. In practicing the methods, an alkaline solution is prepared by dissolving lignin in an alkali solvent, together with porphyrin serving as a photocatalyst, and the resulting alkaline solution is irradiated with light. This is the case where voltage can be generated most efficiently, as demonstrated by the above-mentioned experiments.

In the present invention, porphyrin having a carboxyl group in the molecule can be preferably used as a pyrrole compound such as porphyrin to be added to lignin. Of the porphyrins having a carboxyl group, for example, porphyrin having a total of 2, 4 or 8 carboxyl groups in the molecule can be used as the porphyrin.

Lignin is not limited to those of high purity which are free from impurities, for example, a reducing sugar and β-glucan such as cellulose. That is, conditions such as the presence of impurities as evidenced by somewhat low purity or insolubility in water, the average molecular weight of lignin, or solubility in water, are not limitative.

According to the present invention, the reaction is allowed to proceed further, whereby lignin is photolyzed, so that lignin can be effectively used as a supply source of hydrogen. Hydrogen ions directly liberated from lignin can be fully used, for example, in a fuel cell. That is, a photocatalyst and an alkaline solution, for example, are added to lignin, and the resulting mixture is irradiated with light such as ultraviolet rays or sunlight. By so doing, not only can a photovoltaic cell be prepared conveniently, but hydrogen ions can also be liberated from lignin. Concretely, a product having high purity and free from impurities such as a reducing sugar and cellulose (a product of SIGMA Company, Catalogue No. 471003, molecular weight 60,000), and a product containing a reducing sugar and having slightly low purity (a product of SIGMA Company, Catalogue No. 471038, molecular weight 52,000), for example, are available as the lignin. Hydrogen ions can be liberated from all such products to lower the pH of the solution. That is, hydrogen ions can be liberated from lignin, regardless of the presence of impurities or the average molecular weight of lignin.

In the present invention, hydrogen ions can be liberated more efficiently by irradiating a lignin-alkaline solution, for example, with ultraviolet rays at a wavelength in the vicinity of 300 to 400 nm or light having a wide wavelength range such as sunlight. The wavelength is not limited to the ultraviolet region. In performing photolysis of lignin, hydrogen ions can be liberated by allowing a biologically produced pyrrole compound (see PCT/JP2008/071828), for example, to act on lignin.

The concrete procedure is as follows: In the method of liberating hydrogen ions from lignin, a product having high purity and free from impurities such as a reducing sugar and cellulose (a product of SIGMA Company, Catalogue No. 471003, molecular weight 60,000) is used as lignin. In this case, 1 ml of a solution containing 2.5 mg/ml of lignin was placed in a cylindrical tube having transparency, say, close to that of Eppendorf tube, and was irradiated for 24 hours with ultraviolet rays at a wavelength, say, in the vicinity of 300 to 400 nm or sunlight. As a result, the pH of the lignin reaction mixture lowered from 9.4 to 7.3. This is suggestive of the occurrence of hydrogen ions.

When hydrogen ions are to be liberated from lignin, moreover, a product having high purity and free from impurities such as a reducing sugar and cellulose (a product of SIGMA Company, Catalogue No. 471003, molecular weight 60,000) is used as the lignin. A solution (1 ml) containing 2.5 mg/ml of lignin and 2.5 mM of KOH was irradiated for 24 hours with ultraviolet rays at a wavelength, say, in the vicinity of 300 to 400 nm or sunlight. As a result, the pH of the lignin reaction mixture lowered from 10.4 to 8.0. This is suggestive of the occurrence of hydrogen ions.

In a technology for liberating hydrogen ions from lignin, moreover, a product having high purity and free from impurities such as a reducing sugar and cellulose (a product of SIGMA Company, Catalogue No. 471003, molecular weight 60, 000) is used as the lignin.

By further adding a pyrrole compound, such as porphyrin, as a photocatalyst to a lignin solution, as described above, hydrogen ions can be liberated. As the pyrrole compound, one biologically produced using *Escherichia coli* or the like (patent pending: JP Appln. No. 2007-310116) can be used.

In this case, 1 ml of a solution containing 50 µg/ml of porphyrin (see PCT/JP2008/071828) and 2.5 mg/ml of lignin, for example, was placed in a cylindrical tube having transparency, say, close to that of Eppendorf tube, and was irradiated for 12 hours with ultraviolet light at a wavelength of 365 nm. As a result, the pH of the lignin reaction mixture lowered from 9.2 to 6.4.

In light of the foregoing results, hydrogen ions canbe liberated from lignin by irradiating lignin with ultraviolet rays or light of a wide wavelength range, such as sunlight. By constructing a device for collecting such hydrogen ions, therefore, a fuel supply device for a fuel cell can be constituted.

### [Explanations of Letters or Numerals]

1 Front member
2, 4, 8, 10 Electrode
3, 6, 9 Spacer
5, 7 Membrane
11 Back member
G Glass electrode
M Ion exchange membrane
MK Carbon electrode

## Claims

1. A photovoltaic cell, comprising:
a cell formed by charging an alkaline solution, which contains lignin and porphyrin as solutes, into a space at least partly formed by a transparent member pervious to light; and
a pair of electrodes provided to oppose the alkaline solution of the cell while making contact with the alkaline solution.

2. A photovoltaic cell, comprising:
one cell formed by charging an alkaline solution, which contains lignin and porphyrin as solutes, into one of at least two spaces separated from each other by a membrane, the one cell being at least partly formed by a transparent member pervious to light;
the other cell formed by charging the alkaline solution into the other of the spaces;
one electrode in contact with the alkaline solution of the one of the cells; and
the other electrode in contact with the alkaline solution of the other of the cells.

3. A photovoltaic cell, comprising:
one cell formed by charging an alkaline solution, which contains lignin as a solute, into one of at least two spaces separated from each other by a membrane, the one cell being at least partly formed by a transparent member pervious to light;
the other cell formed by charging the alkaline solution into the other of the spaces;
one electrode in contact with the alkaline solution of the one of the cells; and
the other electrode in contact with the alkaline solution of the other of the cells.

4. A photovoltaic cell, comprising:
one cell formed by charging an alkaline solution, which contains porphyrin as a solute, into one of at least two spaces separated from each other by a membrane, the one cell being at least partly formed by a transparent member pervious to light;
the other cell formed by charging the alkaline solution into the other of the spaces;
one electrode in contact with the alkaline solution of the one of the cells; and
the other electrode in contact with the alkaline solution of the other of the cells.

5. The photovoltaic cell according to any one of claims 1 to 4, wherein the alkaline solution is a solution of potassium hydroxide.

6. The photovoltaic cell according to any one of claims 2 to 5, wherein the membrane is formed of an ion exchange membrane.

7. The photovoltaic cell according to any one of claims 2 to 5, wherein the membrane is formed of a water repellent carbon membrane.

8. The photovoltaic cell according to claim 1, 2 or 4, wherein the porphyrin is coproporphyrin.

## Amended claims

### Amended claims under Art. 19.1 PCT

1. A photovoltaic cell, comprising:
a cell formed by charging an alkaline solution, which contains lignin and porphyrin as solutes, into a space at least partly formed by a transparent member pervious to light; and
a pair of electrodes provided to oppose the alkaline solution of the cell while making contact with the alkaline solution.

2. A photovoltaic cell, comprising:
one cell formed by charging an alkaline solution, which contains lignin and porphyrin as solutes, into one of at least two spaces separated from each other by a membrane, the one cell being at least partly formed by a transparent member pervious to light;
the other cell formed by charging the alkaline solution into the other of the spaces;
one electrode in contact with the alkaline solution of the one of the cells; and
the other electrode in contact with the alkaline solution of the other of the cells.

3. (Deleted)

4. (Deleted)

5. (Amended)
The photovoltaic cell according to claim 1 or 2, wherein the alkaline solution is a solution of potassium hydroxide.

6. The photovoltaic cell according to claim 2 or 5, wherein the membrane is formed of an ion exchange membrane.

7. The photovoltaic cell according to claim 2 or 5, wherein the membrane is formed of a water repellent carbon membrane.

8. The photovoltaic cell according to claim 1 or 2, wherein the porphyrin is coproporphyrin.

Statement under Art. 19.1 PCT
1. Deletion of claims 3 and 4
 This is in response to the following indication in the column "Opinions on international application" of the International Search Report: "The inventions according to claims 3 and 4, which recite photovoltaic cells containing only lignin or porphyrin as a solute, can be said not to be sufficiently supported by the Specification". Thus, it is believed that the reason for rejection based on this indication has been resolved.

2. Alkaline solution
 In the experiments which obtained the results of Tables 1 to 6, KOH is a solvent used to form a solution containing lignin and porphyrin as solutes. That is, the experiments show that KOH, an alkaline solution, was used as a solvent in the experiments, and the satisfactory function of a photovoltaic cell was observed. KOH was used simply as a solvent, and any solvent is used without limitation as long as it is capable of dissolving lignin and porphyrin. Any other alkaline solution can similarly dissolve lignin and porphyrin. Thus, any such alkaline solution can be used likewise, and the product in each case can be allowed to function as a photovoltaic cell. That is, the experimental results shown in Tables 1 to 6 should be interpreted as showing that when solutions having lignin and porphyrin dissolved therein are irradiated with light, certain voltages can be generated.
